# EUROPEAN PATENT APPLICATION

(11) **EP 4 852 263 A1**
(43) Date of publication of application: **09.12.2026**
(21) Application number: 25181038.8
(22) Date of filing: 05.06.2025
(51) Int. Cl.: H02J 3/00, G01R 31/08, H02J 13/00

(54) **PROBABILISTIC LOCALIZATION OF OUTAGES WITH LIMITED AVAILABLE MEASUREMENTS**

(71) Applicant: Hitachi Energy Ltd, 8050 Zürich (CH)
(72) Inventor: EKOMWENRENREN, Etinosa, Longueuil, J4K 4Y6 (CA); CHMIELOWIEC, Krzysztof, 32-089 Beblo (PL); SHCHETININ, Dmitry, 5600 Lenzburg (CH); WANG, Zhenyuan, Apex, 27502 (US); SHIRSAT, Ashwin, Apex, 27502 (US); BOMBA, Piotr, 26-400 Lipno (PL); JAWAD, Muhammad, 31-315 Kraków (PL); STEFANOWSKA, Emilia, 30-318 Kraków (PL)
(74) Representative: Vossius & Partner Patentanwälte Rechtsanwälte mbB

(57) **Abstract**

Some faults within a power network may burn fuses and/or open conductors, but without sufficient current to trip protective devices. Short of deploying expensive fault indicators throughout the power network, the root of outages produced by such faults can be difficult to localize, especially when there are multiple, independent, simultaneous outages. Disclosed embodiments estimate the outage probability of assets within power network 400, using limited real-time measurements and the output of a distribution state estimation. These outage probabilities are then marginalized to produce the probability of each asset being in the off state. Embodiments may utilize these estimates of outage probability to determine the location of root asset(s) that represent the root of each outage in the power network. Such embodiments are able to quickly and accurately identify the root of each outage, even in situations with multiple, independent, simultaneous outages, resulting in faster and more efficient power restoration.

## Description

### BACKGROUND

### Field of the Invention

The embodiments described herein are generally directed to outage localization, and, more particularly, to the probabilistic localization of outages in a power network when available measurements are limited.

### Description of the Related Art

Faults in an electrical power distribution network can cause protective devices to trip or become damaged, which may result in customer power outages. Protective devices, such as circuit breakers and reclosers, are often part of the Supervisory Control and Data Acquisition (SCADA) system of the power distribution network. Outages that are triggered by faults that have sufficient current magnitude to trip such SCADA devices can be quickly detected. This enables the restoration process to be quickly initiated, so as to minimize the outage durations for customers.

However, some faults, that result in burnt fuses and/or open conductors, do not have sufficient current magnitude to trip these SCADA devices. Consequently, such faults can be difficult to detect, and even more difficult to locate and remedy.

To detect such faults, utilities typically rely on customer trouble calls, supplemented by binary status information from Automated Metering Infrastructure (AMI) smart meters, to estimate the outage scope, as exemplified in U.S. Patent Pub. No. 2013/0338945, published on December 19, 2013. As used herein, the term "outage scope" refers to the root (e.g., source) of the outage and the affected service area. Generally, the utility will wait until a confidence threshold of trouble calls is reached, before having sufficient confidence in its estimates to dispatch a field crew.

However, many customers do not usually call to report an outage, and those customers that do call often delay reporting until they have confirmed that the outage is not isolated to their property (e.g., apartment, building, etc.). The resulting delays increase the duration of the outage, which negatively impacts the quality level of customer service. Notably, violations of service-quality levels may result in regulatory penalties.

Once the threshold of trouble calls has reached the confidence threshold, conventional outage analysis typically traces the locations of the trouble calls to the first upstream protective device that covers all locations of the received trouble calls. This method can be unreliable and inefficient in situations where multiple independent outages occur and can result in overly broad estimates of the outage scope. For instance, identifying a single common upstream protective device for independent faults, affecting different areas, may unnecessarily enlarge the perceived outage scope. In turn, this negatively impacts the timing and efficiency of the restoration process.

To improve the localization of faulted power-line sections in power distribution networks, fault identification approaches have been proposed that rely on near-real-time or recorded transient fault data. Examples of such approaches include Zhu, et al., "Faulty Line Identification Method Based on Bayesian Optimization for Distribution Network," IEEE Access, vol. 9, pp. 83175-83184, 2021, doi: 10.1109/ACCESS.2021.3087131, and Yin, et al., "High-Impedance Fault Section Location for Distribution Networks Based on t-Distributed Stochastic Neighbor Embedding and Variable Mode Decomposition," J. Mod. Power Syst. Clean Energy, 2023. However, these approaches depend on the availability of high-resolution dynamic data. Typically, this requires the presence of fault indicator devices in sufficient numbers to cover all of the power-line sections in the power network.

Other fault identification approaches estimate outage locations in the power distribution network utilizing available static SCADA and AMI measurements, via weighted-least-squares-based mixed-integer-programming formulations. Examples of such approaches include Soltani, et al., "Simultaneous robust state estimation, topology error processing, and outage detection for unbalanced distribution systems," IEEE Trans. Power Syst., vol. 38, no. 3, pp. 2018-2034, 2022, and Gandluru, et al., "Joint estimation of operational topology and outages for unbalanced power distribution systems," IEEE Trans. Power Syst., vol. 35, no. 1, pp. 605-617, 2019. However, these deterministic approaches have significant drawbacks in power networks with limited measurements, resulting from poor observability. In particular, such approaches cannot adequately quantify the uncertainties in measurement and model errors, which is required for effective decision-making when available measurements are limited.

Sevlian, et al., "Outage detection using load and line flow measurements in power distribution systems," IEEE Trans. Power Syst., vol. 33, no. 2, pp. 2053-2069, 2017, incorporates measures of uncertainty, due to limited measurements, in a maximum-likelihood framework for outage detection in power distribution networks. This approach produces the outage hypothesis with the highest probability, given the available measurements. However, as with other methods of point estimation in situations with limited measurements, knowing only the most probable outage hypothesis is often insufficient for informed and nuanced decision-making. In particular, there is often a need to quantify the probabilities of various outage hypotheses to enable operators to effectively assess risks and uncertainties.

### SUMMARY

Accordingly, systems, methods, and non-transitory computer-readable media are disclosed for probabilistic localization of outages in a power network when available measurements are limited. A first objective achievable by disclosed embodiments is faster verification of outage scope. A second objective achievable by disclosed embodiments is improved outage localization in situations with multiple, independent outages. A third objective achievable by disclosed embodiments is improved computational speed and/or accuracy in outage localization.

In an embodiment, a method, for locating a root of an outage in a power network, comprises using at least one hardware processor to: obtain a prior probability distribution for a plurality of assets in a power network; sample a first plurality of outage hypotheses from the prior probability distribution; for each of the first plurality of outage hypotheses, estimate one or more measurements in the power network based on a state of the plurality of assets in the outage hypothesis and a state of the plurality of assets that was estimated by a previously executed distribution state estimation, compare the estimated one or more measurements to corresponding real-time measurements in the power network, and weight the outage hypothesis based on the comparison; resample a second plurality of outage hypotheses from the prior probability distribution based on the weightings of the first plurality of outage hypotheses; compute a posterior probability distribution for the plurality of assets based on the second plurality of outage hypotheses; and determine a location of each of one or more root assets, each representing a root of an outage in the power network, based on the posterior probability distribution.

Each outage hypothesis may identify at least one of the plurality of assets, which is capable of carrying current, as being in an off state.

Obtaining the prior probability distribution may comprise computing the prior probability distribution using a probabilistic graphical model. The probabilistic graphical model may be a Bayesian network comprising a plurality of nodes that each represents a random variable, and a plurality of directed edges that each represents a dependency between a pair of the plurality of nodes.

The state of the plurality of assets that was estimated by a previously executed distribution state estimation may comprise a nodal power injection at each of a plurality of nodes in the power network.

The distribution state estimation may be executed periodically.

The method may be triggered by one or more customer trouble calls.

The method may further comprise using the at least one hardware processor to dispatch one or more field crews to the location of each of the one or more root assets.

Estimating the one or more measurements in the power network may comprise optimizing an objective function to minimize deviations between, for each of the plurality of assets that are in an off state in the outage hypothesis, a value of at least one parameter of that asset when in the off state and a value of that at least one parameter given values of decision variables that include the one or more measurements. The objective function may comprise a quadratic function with one or more linear constraints. The decision variables may comprise one or more of voltage magnitudes, power injections, or line flows.

Resampling the second plurality of outage hypotheses may comprise, for each of the first plurality of outage hypotheses: defining a proposal probability distribution from the prior probability distribution based on the outage hypothesis; and in each of one or more iterations, until a condition is satisfied, resampling one or more outage hypotheses, to be added to the second plurality of outage hypotheses, from the proposal probability distribution using a resampling procedure. The resampling procedure may be a multinomial resampling procedure. **In** each of the one or more iterations, a parameter may be increased, wherein the parameter represents randomness in the resampling procedure. The condition may comprise the parameter satisfying a predefined threshold. The resampling procedure may prioritize higher weighted outage hypotheses in the first plurality of outage hypotheses over lower weighted outage hypotheses in the first plurality of outage hypotheses.

Determining the location of each of the one or more outages may comprise, for each of at least a subset of the plurality of assets: determining a probability that the asset is in the off state based on the posterior probability distribution; and when the probability satisfies one or more criteria, determining that the asset is in the off state. Determining the location of each of the one or more root assets may further comprise determining, as the location of at least one of the one or more root assets, a most upstream asset that has been determined to be in the off state.

It should be understood that any of the features in the methods above may be implemented individually or with any subset of the other features in any combination. Thus, to the extent that the appended claims would suggest particular dependencies between features, disclosed embodiments are not limited to these particular dependencies. Rather, any of the features described herein may be combined with any other feature described herein, or implemented without any one or more other features described herein, in any combination of features whatsoever. In addition, any of the methods, described above and elsewhere herein, may be embodied, individually or in any combination, in executable software modules of a processor-based system, such as a server, and/or in executable instructions stored in a non-transitory computer-readable medium, for example, as a computer program product.

### BRIEF DESCRIPTION OF THE DRAWINGS

The details of the present invention, both as to its structure and operation, may be gleaned in part by study of the accompanying drawings, in which like reference numerals refer to like parts, and in which:
FIG. 1 illustrates an example infrastructure, in which any of the processes described herein may be implemented, according to an embodiment;
FIG. 2 illustrates an example processing system, by which any of the processes described herein may be executed, according to an embodiment;
FIG. 3 illustrates an example data flow for outage localization and remediation, according to an embodiment;
FIG. 4 illustrates a power network of a target system, according to an embodiment.
FIG. 5 illustrates a process for outage localization, according to an embodiment;
FIG. 6 illustrates a resampling process, according to an embodiment;
FIG. 7 illustrates an aspect of the resampling process, according to a further embodiment; and
FIGS 8A and 8B illustrate examples of an inverse map, according to alternative embodiments.

### DETAILED DESCRIPTION

In an embodiment, systems, methods, and non-transitory computer-readable media are disclosed for probabilistic localization of outages in a power network when available measurements are limited. After reading this description, it will become apparent to one skilled in the art how to implement the invention in various alternative embodiments and alternative applications. However, although various embodiments of the present invention will be described herein, it is understood that these embodiments are presented by way of example and illustration only, and not limitation. As such, this detailed description of various embodiments should not be construed to limit the scope or breadth of the present invention as set forth in the appended claims.

### 1. Infrastructure

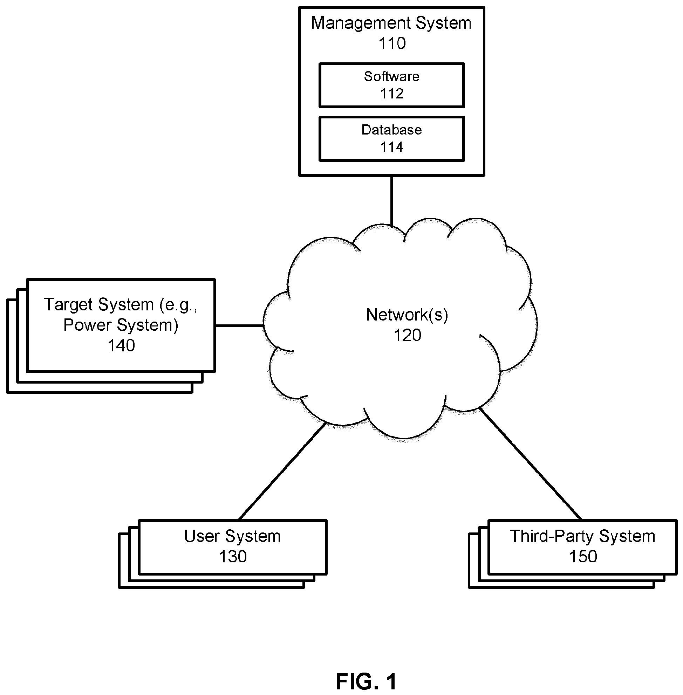

FIG. 1 illustrates an example infrastructure in which any of the disclosed processes may be implemented, according to an embodiment. The infrastructure may comprise a management system 110 (e.g., comprising one or more servers) that hosts and/or executes one or more of the various processes described herein, which may be implemented in software and/or hardware. Examples of management system 110 include, without limitation, a supervisory control and data acquisition (SCADA) system, a power management system (PMS), an energy management system (EMS), a distribution management system (DMS), an advanced DMS (ADMS), an asset management system (ASM), and the like. Management system 110 may comprise dedicated servers, or may instead be implemented in a computing cloud, in which the computational resources of one or more servers are dynamically and elastically allocated to multiple tenants based on demand. In either case, the servers may be collocated (e.g., in a single data center) and/or geographically distributed (e.g., across a plurality of data centers). Management system 110 may also comprise or be communicatively connected to software 112 and/or a database 114. In addition, management system 110 may be communicatively connected, via one or more networks 120, to one or more user systems 130, target systems 140, and/or third-party systems 150.

Network(s) 120 may comprise the Internet, and management system 110 may communicate with user system(s) 130, target system(s) 140, and/or third-party system(s) 150, through the Internet and/or other network using standard transmission protocols, such as HyperText Transfer Protocol (HTTP), HTTP Secure (HTTPS), File Transfer Protocol (FTP), FTP Secure (FTPS), Secure Shell FTP (SFTP), eXtensible Messaging and Presence Protocol (XMPP), Open Field Message Bus (OpenFMB), IEEE Smart Energy Profile Application Protocol (IEEE 2030.5), and the like, as well as proprietary protocols. While management system 110 is illustrated as being connected to various systems through a single set of network(s) 120, it should be understood that management system 110 may be connected to the various systems via different sets of one or more networks. For example, management system 110 may be connected to a subset of user systems 130, target systems 140, and/or third-party systems 150 via the Internet, but may be connected to one or more other user systems 130, target systems 140, and/or third-party systems 150 via an intranet. Furthermore, while only a few user systems 130, target systems 140, and third-party systems 150, one instance of software 112, and one database 114 are illustrated, it should be understood that the infrastructure may comprise any number of user systems 130, target systems 140, third-party systems 150, software instances 112, and databases 114.

User system(s) 130 may comprise any type or types of computing devices capable of wired and/or wireless communication, including without limitation, desktop computers, laptop computers, tablet computers, smart phones or other mobile phones, servers, game consoles, televisions, set-top boxes, electronic kiosks, point-of-sale terminals, embedded controllers, programmable logic controllers (PLCs), and/or the like. However, it is generally contemplated that user system(s) 130 would comprise personal computers, mobile devices, or workstations by which agents of an operator (e.g., utility) of a target system 140 can interact with management system 110. These interactions may comprise inputting data (e.g., parameters for configuring the processes described herein) and/or receiving data (e.g., the outputs of processes described herein) via a graphical user interface provided by management system 110 or a system between management system 110 and user system(s) 130. The graphical user interface may comprise screens (e.g., webpages) that include a combination of content and elements, such as text, images, videos, animations, references (e.g., hyperlinks), frames, inputs (e.g., textboxes, text areas, checkboxes, radio buttons, drop-down menus, buttons, forms, etc.), scripts (e.g., JavaScript), and the like, including elements comprising or derived from data stored in database 114.

Target system(s) 140 may comprise any type of system for which data are monitored, analyzed, and/or acted upon. In the context of specific, non-limiting examples that are provided throughout the present disclosure, it will be assumed that target system 140 comprises or consists of a power system. A power system may comprise one or more, and generally a plurality of, power assets connected in a network, referred to herein as a "power network," which may include a power distribution network, a power transmission network, and/or the like. The power assets may comprise power resources, such as power generators, energy storage systems, electrical loads (e.g., rechargeable energy storage system or other controllable load, non-controllable load, etc.), and/or the like, as well as other types of power assets, such as transformers, inverters, branches or other lines, and/or any other electrical component supporting the power system. Power generators may comprise different types of power generators, such as thermal power plants (e.g., coal, natural gas, nuclear, geothermal, etc.), hydroelectric power plants, renewable resource power plants (e.g., solar, wind, geothermal, etc.), and/or the like. Electrical loads may comprise anything that consumes power, including, without limitation, electric vehicles, appliances, machines, commercial buildings, residential buildings, and/or the like.

Third-party system(s) 150 may comprise any type or types of computing devices capable of wired and/or wireless communication. However, it is generally contemplated that third-party system 150 would comprise one or more servers that supply extrinsic data to management system 100. The extrinsic data may represent historical, current, and/or forecasted values of one or more parameters, relevant to target system 140, such as weather parameters (e.g., temperature, humidity, wind speed, pressure, etc.), market parameters (e.g., energy prices), socio-political events (e.g., protests, law-enforcement warnings, etc.), and/or the like.

Management system 110 may execute software 112, comprising one or more software modules that implement one or more of the disclosed processes. In addition, management system 110 may comprise, be communicatively coupled with, or otherwise have access to database 114 that stores the data input into and/or output from one or more of the disclosed processes. Any suitable database may be utilized in database 114, including without limitation MySQL^{™}, Oracle^{™}, IBM^{™}, Microsoft SQL^{™}, Access^{™}, PostgreSQL^{™}, MongoDB^{™}, and/or the like, and including cloud-based databases, proprietary databases, and unstructured databases.

### 2. Example Processing Device

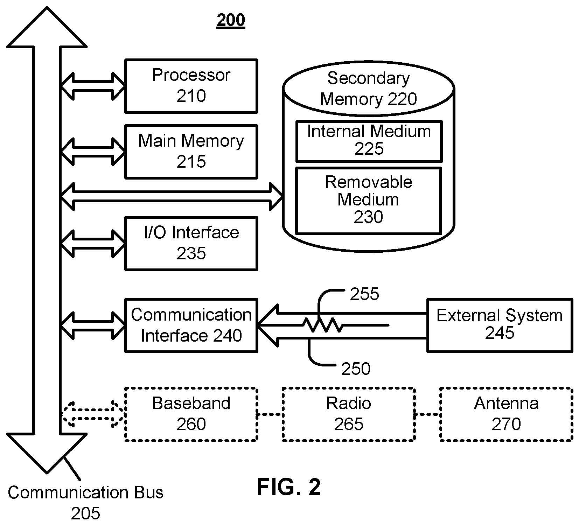

FIG. 2 is a block diagram illustrating an example wired or wireless system 200 that may be used in connection with various embodiments described herein. For example, system 200 may be used as or in conjunction with one or more of the functions, methods, or other processes (e.g., to store and/or execute software 112, store database 114, etc.) described herein, and may represent components of management system 110, user system(s) 130, target system(s) 140, third-party system(s) 150, and/or other processing devices described herein. System 200 can be a server, conventional personal computer, or any other processor-enabled device that is capable of wired or wireless data communication. Other computer systems and/or architectures may be also used, as will be clear to those skilled in the art.

System 200 preferably includes one or more processors 210. Processor(s) 210 may comprise a central processing unit (CPU). Additional processors may be provided, such as a graphics processing unit (GPU), an auxiliary processor to manage input/output, an auxiliary processor to perform floating-point mathematical operations, a special-purpose microprocessor having an architecture suitable for fast execution of signal-processing algorithms (e.g., digital-signal processor), a processor subordinate to the main processor (e.g., back-end processor), an additional microprocessor or controller for dual or multiple processor systems, and/or a coprocessor. Such auxiliary processors may be discrete processors or may be integrated with a main processor 210. Examples of processors 210 which may be used with system 200 include, without limitation, any of the processors (e.g., Pentium^{™}, Core i7^{™}, Xeon^{™}, etc.) available from Intel Corporation of Santa Clara, California, any of the processors available from Advanced Micro Devices, Incorporated (AMD) of Santa Clara, California, any of the processors (e.g., A series, M series, etc.) available from Apple Inc. of Cupertino, any of the processors (e.g., Exynos^{™}) available from Samsung Electronics Co., Ltd., of Seoul, South Korea, any of the processors available from NXP Semiconductors N.V. of Eindhoven, Netherlands, and/or the like.

Processor 210 may be connected to a communication bus 205. Communication bus 205 may include a data channel for facilitating information transfer between storage and other peripheral components of system 200. Furthermore, communication bus 205 may provide a set of signals used for communication with processor 210, including a data bus, address bus, and/or control bus (not shown). Communication bus 205 may comprise any standard or non-standard bus architecture such as, for example, bus architectures compliant with industry standard architecture (ISA), extended industry standard architecture (EISA), Micro Channel Architecture (MCA), peripheral component interconnect (PCI) local bus, standards promulgated by the Institute of Electrical and Electronics Engineers (IEEE), including IEEE 488 general-purpose interface bus (GPIB) or IEEE 696/S-100, and/or the like.

System 200 may comprise a main memory 215. Main memory 215 provides storage of instructions and data for programs executing on processor 210, such as one or more of the processes discussed herein (e.g., embodied in software 112). It should be understood that programs stored in the memory and executed by processor 210 may be written and/or compiled according to any suitable language, including without limitation C/C++, Java, JavaScript, Perl, Visual Basic, .NET, and the like. Main memory 215 is typically semiconductor-based memory such as dynamic random access memory (DRAM) and/or static random access memory (SRAM). Other semiconductor-based memory types include, for example, synchronous dynamic random access memory (SDRAM), Rambus dynamic random access memory (RDRAM), ferroelectric random access memory (FRAM), and the like, including read only memory (ROM).

System 200 may also comprise a secondary memory 220. Secondary memory 220 may optionally include an internal medium 225 and/or a removable medium 230. Internal medium 225 may comprise, for example, a hard disk drive (HDD), a solid state drive (SSD), and/or the like. Removable medium 230 may comprise, for example, a magnetic tape drive, a compact disc (CD) drive, a digital versatile disc (DVD) drive, a flash memory drive, and/or the like. Secondary memory 220 is a non-transitory computer-readable medium having computer-executable code (e.g., software 112) and/or other data stored thereon. The computer software or data stored on secondary memory 220 is read into main memory 215 for execution by processor 210.

System 200 may comprise an input/output (I/O) interface 235. I/O interface 235 provides an interface between one or more components of system 200 and one or more input and/or output devices. Example input devices include, without limitation, sensors, keyboards, touch screens or other touch-sensitive devices, cameras, biometric sensing devices, computer mice, trackballs, pen-based pointing devices, and/or the like. Examples of output devices include, without limitation, other processing devices, cathode ray tubes (CRTs), plasma displays, light-emitting diode (LED) displays, liquid crystal displays (LCDs), printers, vacuum fluorescent displays (VFDs), surface-conduction electron-emitter displays (SEDs), field emission displays (FEDs), and/or the like. In some cases, an input and output device may be combined, such as in the case of a touch panel display (e.g., in a smartphone, tablet, or other mobile device).

System 200 may comprise a communication interface 240. Communication interface 240 allows software and other data to be transferred between system 200 and external devices, networks, or other external systems 245. For example, data, which may include computer software or executable code, may be transferred to system 200 from external system 245 (e.g., a network server, personal computer, or other device) and/or from system 200 to external system 245, via communication interface 240. Examples of communication interface 240 include a built-in network adapter, network interface card (NIC), Personal Computer Memory Card International Association (PCMCIA) network card, card bus network adapter, wireless network adapter, Universal Serial Bus (USB) network adapter, modem, a wireless data card, a communications port, an infrared interface, an IEEE 1394 fire-wire, and any other device capable of interfacing system 200 with a network (e.g., network(s) 120) or another computing device. Communication interface 240 preferably implements industry-promulgated protocol standards, such as Ethernet IEEE 802 standards, Fiber Channel, digital subscriber line (DSL), asynchronous digital subscriber line (ADSL), frame relay, asynchronous transfer mode (ATM), integrated services digital network (ISDN), personal communications services (PCS), transmission control protocol/Internet protocol (TCP/IP), serial line Internet protocol/point to point protocol (SLIP/PPP), and so on, but may also implement customized or non-standard interface protocols as well.

Data transferred via communication interface 240 are generally in the form of electrical communication signals 255. These signals 255 may be provided to communication interface 240 via a communication channel 250. In an embodiment, communication channel 250 may be a wired or wireless network (e.g., network(s) 120), or any variety of other communication links. Communication channel 250 carries signals 255 and can be implemented using a variety of wired or wireless communication means including wire or cable, fiber optics, conventional phone line, cellular phone link, wireless data communication link, radio frequency ("RF") link, or infrared link, just to name a few.

Computer programs (e.g., comprised in software 112), comprising computer-executable code or instructions, are stored in main memory 215 and/or secondary memory 220. Computer programs can also be received via communication interface 240 and stored in main memory 215 and/or secondary memory 220. The computer programs, when executed, enable system 200 to perform one or more of the processes described elsewhere herein.

In this description, the term "computer-readable medium" is used to refer to any non-transitory computer-readable storage media used to provide computer-executable code and/or other data to or within system 200. Examples of such media include main memory 215, secondary memory 220 (including internal memory 225 and/or removable medium 230), and any peripheral device communicatively coupled with communication interface 240, such as external system 245. These non-transitory computer-readable media are means for providing executable code, programming instructions, software, and/or other data to processor(s) 210.

System 200 may also include optional wireless communication components that facilitate wireless communication over a voice network and/or a data network (e.g., in the case of user system 130 that is a smart phone or other mobile device, a sensor and/or actuator within a target system 140, etc.). The wireless communication components comprise an antenna system 270, a radio system 265, and a baseband system 260. In system 200, radio frequency (RF) signals are transmitted and received over the air by antenna system 270 under the management of radio system 265.

In an embodiment, antenna system 270 may comprise one or more antennae and one or more multiplexors (not shown) that perform a switching function to provide antenna system 270 with transmit and receive signal paths. In the receive path, received RF signals can be coupled from a multiplexor to a low noise amplifier (not shown) that amplifies the received RF signal and sends the amplified signal to radio system 265.

In an alternative embodiment, radio system 265 may comprise one or more radios that are configured to communicate over various frequencies. In an embodiment, radio system 265 may combine a demodulator (not shown) and modulator (not shown) in one integrated circuit (IC). The demodulator and modulator can also be separate components. In the incoming path, the demodulator strips away the RF carrier signal leaving a baseband receive signal, which is sent from radio system 265 to baseband system 260.

Baseband system 260 is also communicatively coupled with processor(s) 210, which may have access to data storage areas 215 and 220. Thus, data, including computer programs, can be received from baseband processor 260 and stored in main memory 210 or in secondary memory 220, or executed upon receipt. Such computer programs, when executed, may enable system 200 to perform one or more of the disclosed processes.

### 3. Example Data Flow for Target System Management

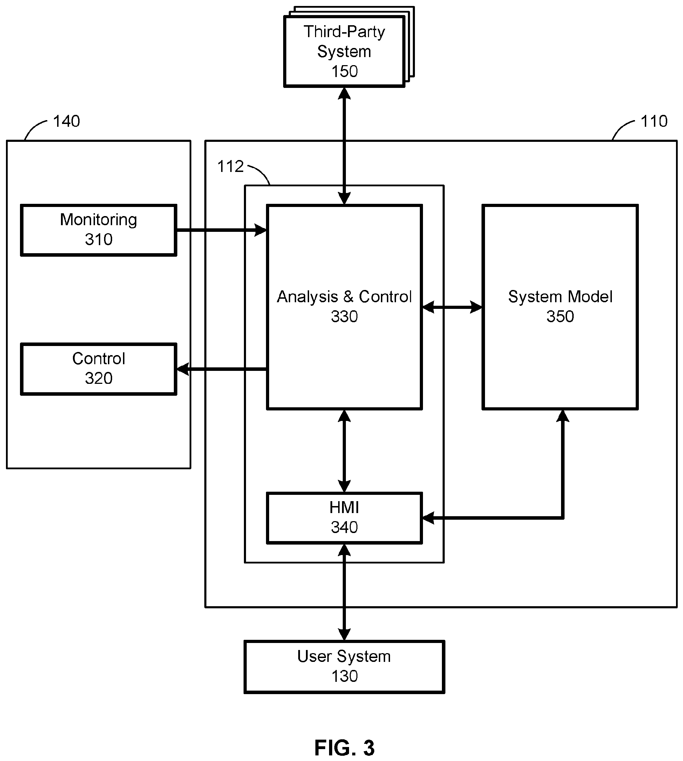

FIG. 3 illustrates an example data flow between a management system 110, a user system 130, a target system 140, and one or more third-party systems 150, according to an embodiment. Target system 140 may comprise a monitoring module 310 and a control module 320. Software 112 of management system 110 may comprise an analysis and control module 330, and a human-to-machine interface (HMI) 340. Analysis and control module 330 may interact with or comprise a system model 350, which may be stored in database 114 of management system 110. It should be understood that communications between the various systems may be performed via network(s) 120. In addition, communications between a pair of modules may be performed via an application programming interface (API) provided by one of the modules or by other inter-process communication means.

Monitoring module 310 may monitor and collect data that are output by one or more sensors in target system 140 (e.g., sensors in a power network). Monitoring module 310 may also otherwise derive data from the collected data. Monitoring module 310 may transmit or "push" the collected and/or otherwise derived data as system telemetry to analysis and control module 330 (e.g., via an API of analysis and control module 330). Alternatively, analysis and control module 330 may retrieve or "pull" the system telemetry from monitoring module 310 (e.g., via an API of monitoring module 310). The system telemetry may include measurements at each of one or more nodes (e.g., buses) or other points within a power network of target system 140. The system telemetry may be communicated from monitoring module 310 to analysis and control module 330 in real time, as data are collected and/or otherwise derived, or periodically. As used herein, the term "real time" includes events that occur simultaneously, as well as events that are separated in time by ordinary delays resulting from latencies in processing, memory access, communications, and/or the like, which are sometimes referred to as "near-real time."

Analysis and control module 330 may receive the system telemetry from monitoring module 310, use the system telemetry in conjunction with system model 350 to determine a configuration for target system 140 (e.g., one or more resources or other power assets in a power system), and then control target system 140 to transition to the determined configuration. In particular, analysis and control module 330 may generate control signals that are transmitted to control module 320 of target system 140. For example, the control signals may be sent via an API of control module 320. The control signals may be communicated from analysis and control module 330 of management system 110 to control module 320 of target system 140 in real time, as the system telemetry is received and analyzed, periodically (e.g., in advance of a sliding time window), or in response to a user operation. Analysis and control module 330 may control target system 140 automatically (e.g., without any user intervention), semi-automatically (e.g., requiring user approval or confirmation), and/or in response to manual user inputs.

Each third-party system 150 may supply extrinsic data to analysis and control module 330. Third-party system 150 may transmit or push the extrinsic data to analysis and control module 330 (e.g., via an API of analysis and control module 330). Alternatively, analysis and control module 330 may retrieve or pull the extrinsic data from third-party system 150 (e.g., via an API of third-party system 150). The extrinsic data may include any data that are utilized by analysis and control module 330 and that are not available from an intrinsic source, such as monitoring module 310 or database 114. The extrinsic data may comprise or consist of data that are exogenous to target system 140. In the context of target system 140 being a power system (e.g., comprising a power network), the exogenous data may comprise one or more historical and/or forecast weather parameters, such as temperature, humidity, solar insolation, wind, barometric pressure, precipitation, alerts, and/or the like. In this case, third-party system 150 may comprise a weather service, such as the United States National Weather Service. As another example, the extrinsic data may comprise one or more historical and/or forecast market parameters, such as an energy price in a primary or ancillary services market. In this case, third-party system 150 may comprise an energy market in which energy is traded.

Analysis and control module 330 may receive intrinsic data from monitoring module 310 and/or database 114 and/or receive extrinsic data from one or more third-party systems 150, and derive the value of each of one or more input features from the received intrinsic and/or extrinsic data. The received data may itself comprise the value of an input feature, or the value of an input feature may be otherwise derived (e.g., calculated, inferred, interpolated, imputed, etc.) from the received data. Analysis and control module 330 may input the values of the input features into a system model 350, which may output values of a target.

Analysis and control module 330 may make decisions and/or perform operations on target system 140, based on the value of the target output by system model 350. As an example, analysis and control module 330 may utilize the value of the target to determine an optimal configuration of target system 140 at some future time. Based on this determination, analysis and control module 330 may automatically (i.e., without any user involvement), semi-automatically (e.g., with user approval or confirmation via human-to-machine interface 340), or manually (e.g., in response to a manual user request) initiate a control operation, to change a real-time or scheduled operation of target system 140, based on the optimal configuration. Initiation of the control operation may comprise transmitting control commands to control module 320 of target system 140, which may responsively control target system 140 according to the control commands.

Of particular relevance to disclosed embodiments, in the event of an outage, analysis and control module 330 may receive intrinsic data from monitoring module 310 and/or database 114, including available real-time measurements and a state of assets in a power network of target system 140, estimated by a distribution state estimation, in combination with a system model 350 of the power network, to determine the scope of the outage. The process for determining the outage scope is described in greater detail elsewhere herein. In an embodiment, the outage scope identifies each asset that represents a root of an outage in the power network. It should be understood that each root asset represents the location of an outage. As used herein, the term "outage" refers to any unplanned partial or complete loss of electrical power supply within the power network of target system 140. Once the outage scope has been determined, analysis and control module 330 may initiate a control operation, comprising one or more control signals, to implement one or more remedial actions that restore power and/or otherwise remediate the outage(s).

Control module 320 of target system 140 may receive the control signals from analysis and control module 330, and control one or more components of target system 140 in accordance with the control signals. In the context of a power system, examples of such control include, without limitation, setting a setpoint (e.g., active and/or reactive power for power generators, voltage, etc.), adjusting the power output of a power generator, adjusting the charging or discharging of an energy storage system, adjusting the power input to a load, activating or deactivating a load, closing or opening a switch (e.g., circuit breaker), and/or the like.

Human-to-machine interface 340 may generate a graphical user interface that is transmitted to user system 130 and receive inputs to the graphical user interface via user system 130. The graphical user interface may provide information regarding the current state of target system 140 determined from the system telemetry, a predicted state of target system 140 determined by analysis and control module 330, a configuration of target system 140 determined by analysis and control module 330, a control decision or recommendation for target system 140 determined by analysis and control module 330, an outage scope that identifies the location of one or more faults in target system 140, and/or the like. In addition, the graphical user interface may provide inputs that enable a user of user system 130 to configure settings of analysis and control module 330, train, configure, test, and/or deploy system model 350, accept or reject decisions, or recommendations, specify, approve, and/or reject controls to be transmitted to control module 320 of target system 140, analyze target system 140, and/or the like.

System model 350 may be stored as a data structure in database 114 and accessed by modules, such as analysis and control module 330, via any known means (e.g., via an API of database 114, a direct query of database 114, etc.). For example, system model 350 may be loaded into memory (e.g., 215 and/or 220) from database 114 and executed by management system 110 as a service (e.g., as a microservice) that is accessible to analysis and control module 330 via an API. Management system 110 may provide an individual system model 350 for each target system 140 that is managed by management system 110, and/or a collective system model 350 that is used for two or more target systems 140. System model 350 may comprise a machine-learning model, representing target system 140, a network topology of target system 140, one or more other attributes of target system 140, and/or the like.

### 4. Power Network

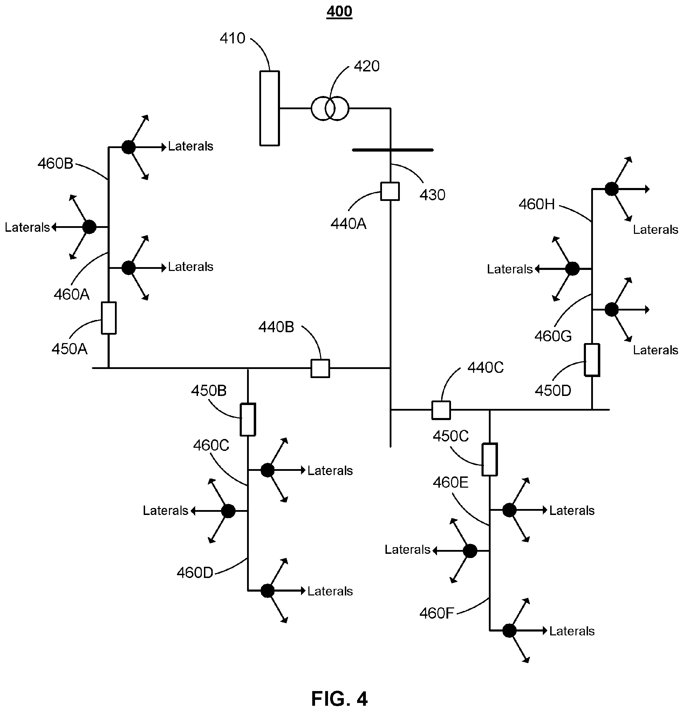

FIG. 4 illustrates a power network 400 of a target system 140, according to an embodiment. The illustrated power network 400 is a radial distribution network. It should be understood that a single, non-limiting example of a power network 400, with a simplified network topology, is illustrated for the purposes of description only. In reality, power network 400 may be significantly more complex with any myriad of network topologies and arrangements of components. As used herein, a reference numeral with an appended letter will be used to refer to a specific component, whereas the same reference numeral without any appended letter will be used to refer collectively to a plurality of the component or to refer to a generic or arbitrary instance of the component.

Power network 400 may comprise a system bus 410 that supplies power through a transformer 420 to one or more feeder lines 430. One or more protective devices 440, illustrated as 440A, 440B, and 440C, may be positioned on feeder line(s) 430. Each protective device 440 may be a SCADA devices that comprises a switch configured to automatically open in the event of a fault (e.g., overload or short circuit) in which the magnitude of the resulting current is sufficient to trip the switch. One or more laterals may be located downstream from each protective device 430.

It should be understood that the term "downstream," in the context of a power network 400, refers to the direction of current. Conversely, the term "upstream" refers to the opposite direction of the current. Thus, for example, transformer 420 is downstream from system bus 410, protective devices 440 are downstream from transformer 420, and the laterals are downstream from protective devices 440, whereas protective devices 440 are upstream from the laterals, transformer 420 is upstream from protective devices 440, and system bus 410 is upstream from transformer 420.

Each lateral may be electrically connected to a feeder line 430 via a fuse 450 and one or more power-line sections 460. For example, during normal operation, fuse 450A provides an electrical connection between feeder line 430 and power-line sections 460A and 460B, fuse 450B provides an electrical connection between feeder line 430 and power-line sections 460C and 460D, fuse 450C provides an electrical connection between feeder line 430 and power-line sections 460E and 460F, and fuse 450D provides an electrical connection between feeder line 430 and power-line sections 460G and 460H.

As is well-known in the art, a fuse 450 is a safety device that protects electrical equipment by interrupting the flow of electricity when an excessive current (e.g., overload or short circuit) occurs. When too much current flows through a fuse 450, a metal wire or strip, which provides electrical conductivity through the fuse 450, melts or "blows" to thereby stop or interrupt the current. It should be understood that, in a radial distribution network, a blown fuse 450 will result in an electrical outage on the respective lateral. The magnitude of a fault current may be sufficient to blow a fuse 450, without tripping a protective device 440. In this case, since fuses 450 are generally not SCADA devices - and therefore, do not supply data to management system 110 - the root of the outage may not be known.

An outage may be modeled as an "off" state for each current-carrying component, referred to herein as an "asset," through which electrical power is not flowing. In other words, an asset is any component of power network 400 that is capable of carrying current, and an off state for an asset, at a given time, means that the asset is not carrying current at the given time. In the case of a protective device 440, the off state would mean that the protective device 440 has tripped (i.e., the switch has opened). In the case of a fuse 450, the off state would mean that the fuse 450 has blown. In the case of a power-line section 460, the off state would mean that the power-line section 460 is broken (e.g., down) or otherwise faulted. Other examples of assets include switches, circuit breakers, and reclosers.

When an outage occurs, an outage hypothesis may be formed. The outage hypothesis represents a possible scenario that might explain the outage. In particular, each outage hypothesis may identify at least one of the plurality of assets in power network 400, which is capable of carrying current, as being in the off state. For example, an outage hypothesis *θ*, for a given time, may comprise a vector of one or more asset identifiers that each identifies an asset (i.e., component capable of carrying current) that is hypothesized to not be carrying current at the given time. Alternatively, the outage hypothesis *θ* may comprise a vector of the states of all assets in the power network, with each asset identified by a fixed position within the vector (e.g., using one-hot encoding). The assets that may be identified in an outage hypothesis *θ* may comprise fuses 450, power-line sections 460, switches, circuit breakers, reclosers, and/or the like.

Using a Bayesian framework, the probability distribution of outage hypotheses *θ* may be computationally approximated, using available real-time measurements y, by a Sequential-Monte-Carlo-(SMC)-based procedure. As is well known in the art, a probability distribution is a function that gives the probabilities of occurrence of possible events, such as, in this context, outages at assets within power network 400. An SMC-based procedure allows for flexibility and scalability to high-dimensional problems, which makes it suitable for large feeder sections with many network components. This probability distribution may then be marginalized to estimate the probabilities of the off states of the plurality of assets (e.g., fuses 450, power-line sections 460, switches, circuit breakers, reclosers, etc.) in power network 400.

The measurement model may be represented by: Expression (1): $Y = G \left(θ; {Z}_{DSE}\right) + ϵ$ wherein *Y* is the set of estimated measurements y, *θ* is the outage hypothesis, *Z_{DSE}* are the nodal power injections estimated by the most recent distribution state estimation (DSE), and ε is the lumped error of the observation process (e.g., including model and forecast errors, measurement noise, etc.). It should be understood that *Z_{DSE}* are estimates of real-time measurements, as opposed to actual real-time measurements, and are sometimes referred to as "pseudo-measurements." A nodal power injection for a node in power network 400 is the amount of power entering or leaving that node. In an embodiment, the error ∈ is modeled as a Gaussian distribution with a zero mean and covariance matrix Γ, i.e., ε ~ *N(0,* Γ). Given the underlying error statistics of pseudo-measurements used in *Z_{DSE},* the covariance matrix Γ can be determined using an importance sampling procedure. 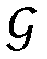 represents the inverse map, which may be defined as the composition of an observational operator 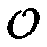 and a solution operator G that maps a realization of the outage hypothesis *θ*, defined by the states of the assets in power network 400, to the measurements Y: Expression (2): $G = O ∘ G$

An alternative measurement model may be represented as: Expression (1b): $\begin{matrix}Y = G \left(θ; {Z}_{DSE}\right) + m + ϵ \\ m = F \left({θ}_{true}; {Z}_{DSE}\right) - G \left({θ}_{true}; {Z}_{DSE}\right)\end{matrix}$ wherein F is a more accurate inverse map, relative to simplified inverse map 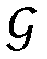 , and *m* is the model error induced by switching from the more accurate inverse map *F* to the simplified inverse map 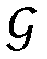 . In other words, the measurement model is augmented by incorporating a model error m for the error induced by an accuracy drop off due to the utilization of a more simplified inverse map 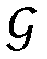 . This is important in situations in which alternative realizations of the inverse map are available, and there is a high premium on providing very fast computations. With this modified measurement model, the SMC-based procedure can be modified to incorporate multilevel Monte-Carlo principles, as described in Latz, et al., "Multilevel sequential2 Monte Carlo for Bayesian inverse problems," J. Comput. Phys., vol. 368, pp. 154-178, 2018, which is hereby incorporated herein by reference as if set forth in full. This reduces the computational cost of the problem, and therefore, increases the computational speed, while maintaining the accuracy of using the more accurate inverse map F.

Given the measurement model in Expression (1) or (1B), the probability density function (PDF) of the distribution of the data y ∈ Y, conditional on the outage hypothesis *θ*, may be defined by: Expression (3): $exp \left(-\frac{1}{2}{\left|\left|{Γ}^{- \frac{1}{2}}\left(y-G\left(θ\right)\right)\right|\right|}_{2}^{2}\right)$ wherein exp is the exponential function. This probability density function, which is referred to herein as the "posterior probability distribution," denoted *π*(θ|*y*) for outage hypothesis *θ* and available measurements y, represents the likelihood that the outage hypothesis *θ* correctly represents the state of power network 400.

In an embodiment, the posterior probability distribution is approximated by updating a prior probability distribution, denoted π₀(*θ*), with the likelihood formed from available real-time measurements. In this context, the term "prior probability distribution" simply refers to the probability distribution that precedes the posterior probability distribution. The prior probability distribution provides an important mechanism for incorporating knowledge about power network 400 into the posterior probability distribution. The posterior probability distribution may be approximated as: Equation (4): $π \left(\left.θ\right|y\right) ∝ exp \left(-\frac{1}{2}{\left|\left|{Γ}^{- \frac{1}{2}}\left(y-G\left(θ\right)\right)\right|\right|}_{2}^{2}\right) {π}_{0} \left(θ\right)$

### 5. Outage Localization

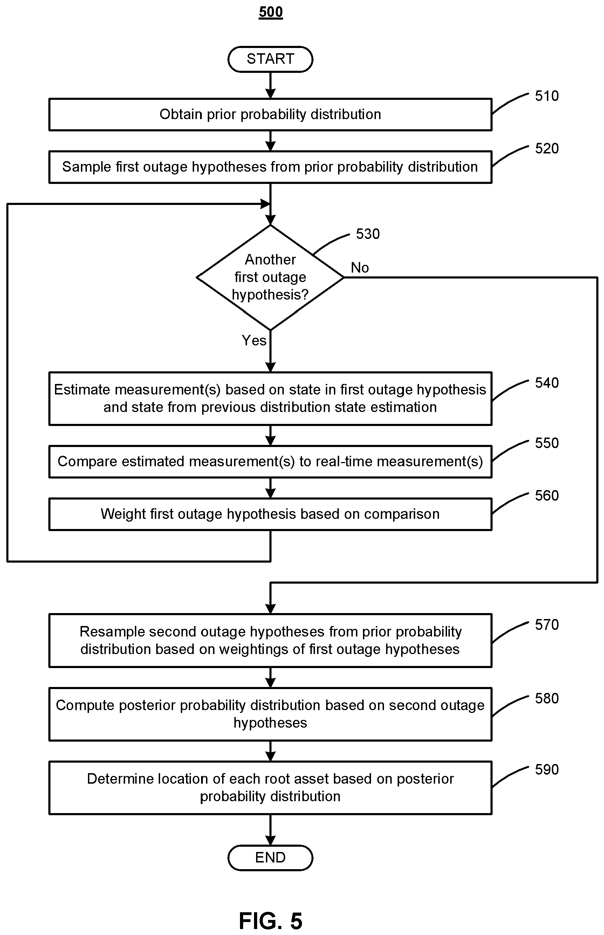

FIG. 5 illustrates a process 500 for outage localization, according to an embodiment. In particular, process 500 may locate the root of an outage in power network 400. Process 500 may be implemented by software 112, for example, as a software module within analysis and control module 330. While process 500 is illustrated with a certain arrangement and ordering of subprocesses, process 500 may be implemented with fewer, more, or different subprocesses and a different arrangement and/or ordering of subprocesses. In addition, it should be understood that any subprocess, which does not depend on the completion of another subprocess, may be executed before, after, and/or in parallel with that other independent subprocess, even if the subprocesses are described or illustrated in a particular order.

Process 500 may be triggered by an indication of an outage. For example, process 500 may be triggered by one or more trouble calls. In an embodiment, the reception of a single trouble call may be sufficient to trigger process 500. Alternatively, process 500 may be triggered only when the number of trouble calls that are received reaches a threshold. In yet another alternative embodiment, process 500 may be triggered by another metric or by a different indication that an outage exists.

Subprocess 510 may obtain a prior probability distribution for a plurality of assets in power network 400. In an embodiment, subprocess 510 comprises computing the prior probability distribution using a probabilistic graphical model. The probabilistic graphical model incorporates information about power network 400, such as the network topology of power network 400, the types of power-line sections 460 (e.g., overhead, underground, etc.) and/or other assets, and/or the like. This enables the encoding of the conditional dependencies of variables, and the modeling of the joint probability distribution of the states of the assets in power network 400.

In the event that power network 400 is a radial network, the probabilistic graphical model may be a Bayesian network comprising a plurality of nodes that each represents a random variable, and a plurality of directed edges that each represents a dependency (e.g., conditional dependency) between a pair of the plurality of nodes. In this case, the Bayesian network can be implemented as a data structure via Conditional Probability Trees (CPTs), with each asset (e.g., fuse 450, power-line section 460, switch, circuit breaker, recloser, etc.) modeled as a node. The state of each node (e.g., whether the asset, represented by the node is in the off state or the on state) may be parameterized by its conditional dependence on other nodes and a Bernoulli distribution 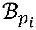 , in which *pᵢ* is the probability of the node being in the on state.

Probability *pᵢ* for an asset/node i can be defined, for example, based on information about the type of asset (e.g., the type of power-line section 460), the outage history of the asset, and/or the like. Alternatively, the probability *pᵢ* for an asset/node i can be assigned a value that encodes the risk premium and cost associated with falsely classifying the asset as in the off state.

Subprocess 520 may sample a first plurality of outage hypotheses from the prior probability distribution. Sampling is required because it is computationally infeasible to evaluate every possible outage hypothesis represented by the prior probability distribution. Advantageously, the probabilistic graphical model (e.g., Bayesian network) encodes the conditional dependence of assets in a topology-aware manner. As a result, every outage hypothesis that is sampled from the prior probability distribution aligns with the topology of power network 400. For example, if an upstream power-line section 460 (e.g., 460A) is in the off state in the outage hypothesis, all downstream power-line sections 460 (e.g., 460B) will also be in the off state in the outage hypothesis. This significantly reduces the search space of possible outage hypotheses, which produces faster and more efficient solutions.

In an alternative embodiment in which the power network is a meshed or weakly meshed distribution network, the probabilistic graphical model may be a Markov Random Field (MRF), instead of a Bayesian network. An undirected Markov Random Field sufficiently represents a meshed network, in which dependencies are mutual and can form cycles. The Markov Random Field encodes conditional dependencies of the asset states, and outputs outage hypotheses reflecting this information. The conditional dependencies can be parameterized in a similar manner as discussed above with respect to the Bayesian network. Using the Markov Random Field, in combination with alternative realizations of the inverse map, embodiments can be applied to meshed or weakly meshed power distribution networks.

Subprocess 530 may determine whether or not another one of the first plurality of outage hypotheses remains to be considered. Essentially, subprocesses 540-560 are performed for each of the first plurality of outage hypotheses. When another one of the first plurality of outage hypotheses remain to be considered (i.e., "Yes" in subprocess 530), process 500 may select the next outage hypothesis to be considered from the first plurality of outage hypotheses, and proceed to subprocess 540. Otherwise, when all of the first plurality of outage hypotheses have been considered (i.e., "No" in subprocess 530), process 500 may proceed to subprocess 570.

Subprocess 540 may estimate one or more measurements in the power network based on a state (e.g., off state or on state) of the plurality of assets in the selected outage hypothesis and a state (e.g., pseudo-measurements, such as nodal power injections) of the plurality of assets that was estimated by a previously executed distribution state estimation. The estimation of the one or more measurements in the power network may comprise optimizing an objective function to minimize deviations between, for each of the plurality of assets that are in an off state in the outage hypothesis, a value of at least one parameter of that asset when in the off state and a value of that at least one parameter given values of decision variables that include the one or more measurements. The objective function may comprise a quadratic function with one or more linear constraints. The decision variables may comprise voltage magnitudes, power injections, line flows, and/or the like. **In** addition, the state of the plurality of assets that was estimated by a previously executed distribution state estimation may comprise a nodal power injection at each of a plurality of nodes in the power network.

The distribution state estimation may be executed periodically. For example, the distribution state estimation may be executed at the expiration of each of a plurality of fixed time intervals, or according to a sliding time window. **In** this case, subprocess 540 may utilize the state (e.g., nodal power injections) of the plurality of assets that was estimated by the most recently executed distribution state estimation. It should be understood that the distribution state estimation may be executed for other reasons than for process 500, as part of an overarching analysis and control loop for power network 400, and that process 500 may repurpose the results of the most recent distribution state estimation. In an alternative embodiment, the state of the plurality of assets may be estimated by an algorithm other than distribution state estimation, such as a load-forecasting or load-allocation algorithm. As another alternative, when granular short-term intraday nodal power injection forecasts are available, such forecasts may be used in lieu of the estimated nodal power injections from a distribution state estimation.

The inverse map 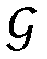 converts a given outage hypothesis *θ* and the estimated nodal power injections *Z_{DSE}* into an estimate *Y* of real-time measurements. In other words, the inverse map 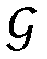 provides an estimate of what the real-time measurements would be if the network topology, implied by the outage hypothesis *θ*, represented the actual state of the plurality of assets in power network 400.

As mentioned above, the inverse map 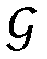 may be formulated as a quadratic optimization problem with linear constraint(s). The linear constraint(s) may represent the linearized power-flow constraints for an arbitrary multi-phase power distribution network, potentially including unbalanced loads. In particular, the inverse map 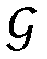 may be formulated as: Expression (5): $\begin{matrix}{min}_{x} {\sum }_{m ∈ {φ}_{m}} {w}_{m} {\left({u}_{m}-{h}_{m}\left(x\right)\right)}^{2} \\ subject to x ∈ F\end{matrix}$ wherein x represents the decision variables (e.g., voltage magnitudes, power injections, line flows, etc.), φₘ is the set of assets in the off state in the given outage hypothesis, *uₘ* represents the estimated value of at least one parameter for asset m when in the off state, *hₘ(x)* represents the value of the same parameter(s) for the asset m given the decision variables *x,* which may comprise estimated measurement(s) *Y,* wₘ represents a cost associated with the soft-penalty constraint for enforcing the decision variables *x* for asset m, and F represents the collection of linearized power-flow constraints for power network 400. A subset of the decision variables x may comprise estimates of physically measured quantities, such as SCADA and/or AMI data. Once the quadratic optimization problem is solved for decision variables x, the estimated measurement(s) Y may be extracted via a selection operator.

Subprocess 550 may compare the estimated one or more measurements to corresponding real-time measurements in the power network. In particular, the difference or deviation between the one or more measurements and their corresponding real-time measurements may be computed. These real-time measurements may represent actually measured parameters, acquired from SCADA devices and/or AMI meters.

Subprocess 560 may weight the selected outage hypothesis based on the comparison from subprocess 550. In general, outage hypotheses for which the estimated measurement(s) are closer in value (i.e., smaller deviation) to the corresponding real-time measurement(s) may be weighted higher than outage hypotheses for which the estimated measurement(s) are further in value (i.e., larger deviation) from the corresponding real-time measurement(s). The weighting of a given outage hypothesis may represent the probability of that outage hypothesis being true. For example, the weighting w for the selected outage hypothesis *θ* may be computed as: Expression (6): $w = \frac{π \left(θ\right)}{{\sum }_{k = 1}^{N} π \left({θ}_{k}\right)}$ wherein N represents the total number of outage hypotheses in the first plurality of outage hypotheses.

Subprocess 570 may resample a second plurality of outage hypotheses from the prior probability distribution based on the weightings of the first plurality of outage hypotheses, as determined in iterations of subprocess 560. During the resampling, first outage hypotheses with higher weightings are prioritized over first outage hypotheses with lower weightings. Thus, the second plurality of outage hypotheses represents a set of different realizations of the first plurality of outage hypotheses, based on the weightings of the first plurality of outage hypotheses. In general, a higher weighting for a given first outage hypothesis may result in a larger sampled number of second outage hypotheses for that first outage hypothesis, relative to a first outage hypothesis with a lower weighting.

Subprocess 580 may compute a posterior probability distribution for the plurality of assets in the power network based on the second plurality of outage hypotheses that were resampled in subprocess 570. The posterior probability distribution *π*(*θ*|*y*) may be estimated over the binary space ${B}^{d}$ by direct sampling using an SMC-based or similar procedure. In an embodiment, likelihood tempering is used. Likelihood tempering comprises gradually increasing a temperature parameter β ∈ (0,1) by a step length α, which may be fixed or dynamic, such that α = *β*_{*t*+1} - *βₜ*, wherein t represents the current time step. In this case, the tempered posterior probability distribution may be given by: Equation (7): $\begin{matrix}π {\left(\left.θ\right|y\right)}^{β} : = {π}^{β} = exp \left(-\frac{1}{2}{\left|\left|{\left(\frac{1}{β}Γ\right)}^{- \frac{1}{2}}\left(y-G\left(θ\right)\right)\right|\right|}_{2}^{2}\right) {π}_{0} \left(θ\right) \\ {π}^{α} = \frac{{π}^{{β}_{t + 1}}}{{π}^{{β}_{t}}}\end{matrix}$

Subprocess 590 may determine a location of each of one or more root assets, each representing a root of an outage in the power network, based on the posterior probability distribution that was computed in subprocess 580. This determination may comprise, for each of at least a subset of the plurality of assets, determining a probability that the asset is in the off state based on the posterior probability distribution, and when the probability satisfies one or more criteria, determining that the asset is in the off state. The one or more criteria may comprise or consist of the probability of being in the off state satisfying (e.g., being greater than or equal to) a predefined threshold. The marginal probability of the states being the off state (i.e., on outage) can be estimated via: Expression (8): $1 - {E}_{π} \approx 1 - {\sum }_{k = 1}^{N} {w}_{k} {θ}_{k}$

The location of at least one, and potentially each, of the one or more root assets may be determined as a most upstream asset, that has been determined to be in the off state and which is downstream from a SCADA device (e.g., protective device 440). It should be understood that in this manner, a plurality of independent outages may be detected in the event that tracing outages upstream results in the discovery of two or more most upstream assets that are each determined to be in the off state and which are not along the same electrical path (i.e., neither is upstream or downstream from the others).

The predefined threshold for determining whether or not an asset is in the off state, based on the probability of that asset being in the off state, may be optimized. In particular, the optimal predefined threshold may be defined as the threshold with the largest Youden's J statistic value, as described in Youden, "Index for rating diagnostic tests," Cancer, vol. 3, no. 1, pp. 32-35, 1950, doi: 10.1002/1097-0142(1950)3:1<32::AID-CNCR2820030106>3.0.CO;2-3, which is hereby incorporated herein by reference as if set forth in full. Youden's J statistic provides an optimal balance between detecting true outages and minimizing costly false positives.

To define the optimal predefined threshold, firstly, a range of probability thresholds may be selected for evaluation, for example, from the range of 0.0 to 1.0, in increments of 0.1, 0.01, or the like. Secondly, for each probability threshold in the selected range, process 500 may be utilized for each of a plurality of simulated outages, to compute the outage probabilities for a range of scenarios, represented in the simulated outages. Thirdly, for each probability threshold, the number of true positives *(TP),* true negatives *(TN),* false positives *(FP),* and false negatives *(FN)* may be calculated based on the true outages and the outages predicted by process 500 using that probability threshold. Fourthly, for each probability threshold, Youden's J statistic may be calculated via: $J = \frac{TP}{TP + FN} + \frac{TN}{TN + FP} - 1$ Fifthly, the probability threshold with the maximum J is selected as the optimal predefined threshold.

### 6. Resampling

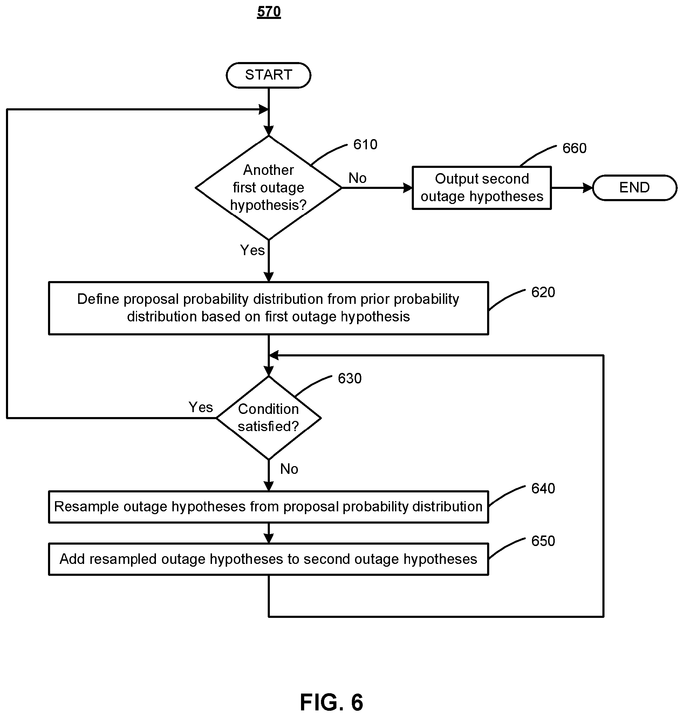

FIG. 6 illustrates resampling subprocess 570, according to an embodiment. While subprocess 570 is illustrated with a certain arrangement and ordering of subprocesses, subprocess 570 may be implemented with fewer, more, or different subprocesses and a different arrangement and/or ordering of subprocesses. **In** addition, it should be understood that any subprocess, which does not depend on the completion of another subprocess, may be executed before, after, and/or in parallel with that other independent subprocess, even if the subprocesses are described or illustrated in a particular order.

Subprocess 610 may determine whether or not another one of the first plurality of outage hypotheses remains to be considered. Essentially, subprocesses 620-650 are performed for each of the first plurality of outage hypotheses. When another one of the first plurality of outage hypotheses remain to be considered (i.e., "Yes" in subprocess 610), subprocess 570 may select the next outage hypothesis to be considered from the first plurality of outage hypotheses, and proceed to subprocess 620. Otherwise, when all of the first plurality of outage hypotheses have been considered (i.e., "No" in subprocess 610), subprocess 570 may proceed to subprocess 660.

Subprocess 620 may define a proposal probability distribution from the prior probability distribution (e.g., obtained in subprocess 510), based on the selected outage hypothesis. The proposal probability distribution may be adaptively computed using the selected outage hypothesis. **In** particular, the proposal probability distribution may be computed by updating the parameters of the probabilistic graphical model (e.g., Bayesian network) used for the prior probability distribution, using the weighting for the selected outage hypothesis. This update may be performed in a Bayesian Maximum-a-Posterior (MAP) setting, in which the update has a closed-form solution.

Subprocess 630 may determine whether or not a condition has been satisfied. This condition represents a stopping condition. Essentially, subprocesses 640-650 are performed in each of one or more iterations, until the condition is satisfied. **In** an embodiment, in each of the iteration(s), a parameter (e.g., representing randomness in the resampling procedure) is increased, and the condition comprises the parameter satisfying (e.g., becoming greater than or equal to) a predefined threshold. The parameter may be the temperature parameter β, and the predefined threshold may be 1.0. When the condition has been satisfied (i.e., "Yes" in subprocess 630), subprocess 570 may return to subprocess 610. Otherwise, when the condition has not yet been satisfied (i.e., "No" in subprocess 630), subprocess 570 may proceed to subprocess 640.

Subprocess 640 may resample one or more outage hypotheses, to be added to the second plurality of outage hypotheses, from the proposal probability distribution, defined in subprocess 620, using a resampling procedure. **In** general, the resampling procedure prioritizes higher weighted outage hypotheses in the first plurality of outage hypotheses over lower weighted outage hypotheses in the first plurality of outage hypotheses. **In** an embodiment, the resampling procedure is a multinomial resampling procedure.

Subprocess 650 may add the resampled one or more outage hypotheses to the second plurality of outage hypotheses. Thus, the second plurality of outage hypotheses are iteratively accumulated, with second outage hypotheses in proximity to first outage hypotheses with higher weightings being added in greater numbers than second outage hypotheses in proximity to first outage hypotheses with lower weightings.

Subprocess 660 may output the second plurality of outage hypotheses, collected over iteration(s) of subprocesses 610-650. For example, the second plurality of outage hypotheses may be output to subprocess 580 of process 500.

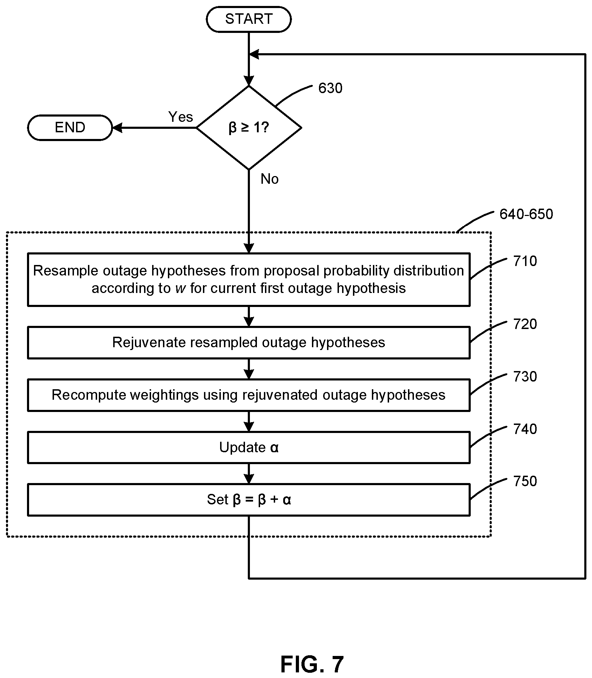

FIG. 7 illustrates resampling subprocesses 630-650, according to a further embodiment. While this subprocess is illustrated with a certain arrangement and ordering of subprocesses, this subprocess may be implemented with fewer, more, or different subprocesses and a different arrangement and/or ordering of subprocesses. **In** addition, it should be understood that any subprocess, which does not depend on the completion of another subprocess, may be executed before, after, and/or in parallel with that other independent subprocess, even if the subprocesses are described or illustrated in a particular order.

**In** the illustrated embodiment, the condition in subprocess 630 is temperature parameter β satisfying (e.g., becoming greater than or equal to) a predefined threshold (e.g., 1.0). Initially, temperature parameter β may be initialized to a value that is less than the predefined threshold, such as zero or a value between zero and the predefined threshold. **In** addition, the step length α may be initialized to a non-zero value that is between zero and the predefined threshold. When temperature parameter β satisfies the predefined threshold (i.e., "Yes" in subprocess 630), this aspect of the resampling subprocess 570 may end. Otherwise, when temperature parameter β does not satisfy the predefined threshold (i.e., "No" in subprocess 630), this aspect of subprocess 570 may proceed to subprocesses 640-650, which are shown in greater detail as subprocesses 710-750.

Subprocess 710 may resample second outage hypotheses from the proposal probability distribution according to the weighting w for the currently selected first outage hypotheses. **In** an embodiment, weighting w is computed according to Expression (6). The weighting w dictates the number (e.g., as a number or percentage) of second outage hypotheses that are resampled from the proposal probability distribution, with greater values of weighting w dictating a larger number than lower values of weighting w. Subprocess 710 may utilize a multinomial resampling procedure, in which a certain number of independent random numbers are drawn from a uniform distribution and used to select particles (i.e., second outage hypotheses) from the proposal probability distribution, with each particle's probability of selection proportional to weighting w.

Subprocess 720 may rejuvenate the second outage hypotheses that were resampled in subprocess 710. Rejuvenation may comprise moving each resampled outage hypothesis into the second plurality of outage hypotheses using an independent Metropolis-Hastings transition kernel, with a stationary distribution *π³.* Each of these Markov-Chain-Monte-Carlo (MCMC) moves may be run for a certain number of iterations, and is parallelizable. The number of iterations in each iteration of subprocess 720 may require drawing new outage hypotheses from the proposal probability distribution.

Subprocess 730 may recompute the weightings using the rejuvenated outage hypotheses, remaining after subprocess 720. Again, the weightings may be computed according to Expression (6).

Subprocess 740 may update step length α, according to any suitable adaptive procedure. Alternatively, in an embodiment in which step length α is fixed, subprocess 740 may be omitted.

Subprocess 750 may update temperature parameter β according to step length α. In particular, temperature parameter β may be incremented by step length α. Then, subprocess 570 may return to subprocess 630.

### 7. Alternative Inverse Map

The particular implementation of inverse map 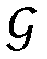 , used in embodiments, may depend on whether accuracy or speed is prioritized. In an embodiment, the quadratic optimization problem, described in the preferred embodiment, may be replaced with an alternative inverse mapping.

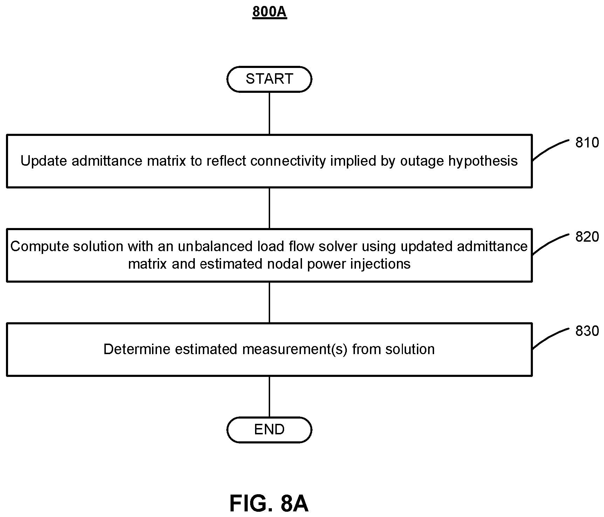

FIG. 8A illustrates an example of an inverse map 800A that prioritizes accuracy, according to an embodiment. At a high level, in this embodiment, the quadratic optimization problem is replaced with a tool that processes the admittance matrix of power network 400, using the connectivity implied by the outage hypothesis, and then performs an unbalanced load-flow computation.

The input to inverse map 800A may comprise the outage hypothesis being considered, the admittance matrix of power network 400, and the estimated nodal power injections (e.g., from the most recent execution of a distribution state estimation). As is well-known in the art, an admittance matrix is a square matrix that relates current injected into buses in power network 400 to the voltages at those buses. Subprocess 810 may update the admittance matrix to reflect the connectivity implied by the outage hypothesis. Subprocess 820 may compute a solution with an unbalanced load flow (UBLF) solver, using the admittance matrix, as updated by subprocess 810, and the estimated nodal power injections. The solution may comprise the voltage at each node in power network 400 and/or the current through each edge in power network 400. Subprocess 830 may determine the estimate measurement(s) from the solution computed in subprocess 820.

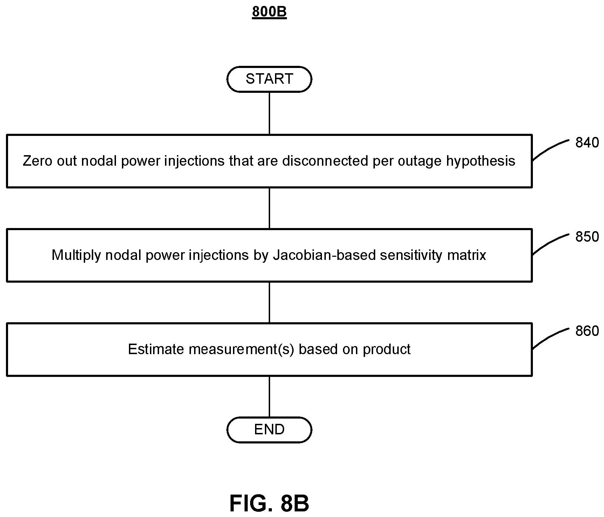

FIG. 8B illustrates an example of an inverse map 800B that prioritizes speed, according to an embodiment. At a high level, in this embodiment, a simplified inverse map may be defined, using the Jacobian-based sensitivity matrix obtained via the linearization around the state of the plurality of assets (i.e., operating point) that was estimated by the most recent distribution state estimation, and used to map processed nodal power injections to the estimated measurement(s). The nodal power injections may be processed using a procedure that effectively sets all nodal power injections, downstream of an asset in the off state in the outage hypothesis, to zero.

The input to inverse map 800B may comprise the outage hypothesis being considered, the Jacobian-based sensitivity matrix, and the estimated nodal power injections (e.g., from the most recent execution of a distribution state estimation). Subprocess 840 may zero out the nodal power injections that are disconnected per the outage hypothesis. In particular, if the outage hypothesis indicates an asset/node as being in the off state, the nodal power injection at that asset/node may be set to zero. In other words, subprocess 840 implements the outage hypothesis. Subprocess 850 may multiply the nodal power injections by the Jacobian-based sensitivity matrix. Subprocess 860 may estimate the measurement(s) based on the product of subprocess 850.

### 8. Example Application

Disclosed embodiments may be triggered by the detection of an outage within power network 400, for example, via reception of one or more customer trouble calls. Embodiments may estimate the outage probability of assets (e.g., fuses 450, power-line sections 460, switches, circuit breakers, reclosers, etc.) within power network 400, using limited real-time measurements and the output of a distribution state estimation. In particular, outage probabilities may be computed using an SMC-based procedure to computationally approximate the conditional probability distribution of the states of the assets, given the available, but limited, real-time measurements, which is then marginalized to produce the probability of each asset being in the off state. Embodiments may utilize these estimates of outage probability to determine the location of the root asset(s) that represent the root of each outage.

Embodiments are capable of verifying customer trouble calls. For example, the estimated outage probabilities can be used to reduce the threshold number of customer trouble calls required to verify an outage. This, in turn, results in the restoration process being initiated sooner, which shortens the overall duration of the outage.

Embodiments are also capable of accurately localizing any arbitrary number of multiple simultaneous and independent outages within power network 400, which may be a multi-phase and/or unbalanced power distribution network. Not only does this improve the outage scope analysis, but more accurate outage localization improves the efficiency of the restoration process, especially in situations involving multiple distinct outages. Fast and accurate outage localization is a key factor in reducing the System Average Interruption Duration Index (SAIDI) and Customer Average Interruption Duration Index (CAIDI), which are reliability indices used by electric power utilities to measure the performance of their power networks 400.

**In** addition, embodiments are capable of working with limited real-time measurements from available SCADA and/or AMI devices. This obviates the need to deploy expensive fault indicator devices throughout power network 400, as required by conventional fault-localization approaches.

Embodiments also provide precise outage probabilities for each asset. These precise asset-specific outage probabilities can be used for more informed, nuanced, and risk-aware decision-making.

**In** an embodiment, once the location of a root asset, representing the root of an outage, is determined, one or more remedial actions may be performed, either automatically, semi-automatically, or manually. One example of a remedial action is to dispatch one or more field crews to the location of each root asset. The improved outage localization ensures that field crews are dispatched to the correct location, so as to restore power as quickly as possible. Other examples of remedial actions include, without limitation, controlling one or more components of power network 400 (e.g., via control module 320) to mitigate the detected outages in the power network, curtailing or shedding one or more loads from power network 400, re-dispatching one or more power generators, tripping one or more power generators, reconfiguring a topology of power network 400, adjusting one or more setpoints of one or more components of power network 400, and/or the like.

As a concrete example of a remedial action, when dispatching a field crew, one or more switches, within power network 400, may be controlled to disconnect current-carrying assets from the root asset on outage, to thereby increase the safety around the root asset for the dispatched field crew. As another concrete example of a remedial action, one or more switches, within power network 400, may be controlled to reroute power supply around the root asset on outage. As yet another concrete example of a remedial action, one or more switches, within power network 400, may be controlled to route power from a power generator to one or more assets or loads downstream from the root asset on outage. As yet another concrete example of a remedial action, the power-output setpoint for a power generator, within power network 400, may be increased to increase power supply to one or more assets or loads downstream from the root asset on outage. As yet another concrete example of a remedial action, a mobile power generator may be dispatched to a connection point that is downstream from the root asset on outage. As yet another concrete example of a remedial action, one or more non-critical loads, being supplied with power by power network 400, may be curtailed. It should be understood that two or more such remedial actions may be combined in any combination whatsoever, and that each remedial action may be performed automatically, semi-automatically, or manually, depending on applicable design and/or safety factors.

The above description of the disclosed embodiments is provided to enable any person skilled in the art to make or use the invention. Various modifications to these embodiments will be readily apparent to those skilled in the art, and the general principles described herein can be applied to other embodiments without departing from the spirit or scope of the invention. Thus, it is to be understood that the description and drawings presented herein represent a presently preferred embodiment of the invention and are therefore representative of the subject matter which is broadly contemplated by the present invention. It is further understood that the scope of the present invention fully encompasses other embodiments that may become obvious to those skilled in the art and that the scope of the present invention is accordingly not limited.

As used herein, the terms "comprising," "comprise," and "comprises" are openended. For instance, "A comprises B" means that A may include either: (i) only B; or (ii) B in combination with one or a plurality, and potentially any number, of other components. In contrast, the terms "consisting of," "consist of," and "consists of" are closed-ended. For instance, "A consists of B" means that A only includes B with no other component in the same context.

Combinations, described herein, such as "at least one of A, B, or C," "one or more of A, B, or C," "at least one of A, B, and C," "one or more of A, B, and C," and "A, B, C, or any combination thereof" include any combination of A, B, and/or C, and may include multiples of A, multiples of B, or multiples of C. Specifically, combinations such as "at least one of A, B, or C," "one or more of A, B, or C," "at least one of A, B, and C," "one or more of A, B, and C," and "A, B, C, or any combination thereof" may be A only, B only, C only, A and B, A and C, B and C, or A and B and C, and any such combination may contain one or more members of its constituents A, B, and/or C. For example, a combination of A and B may comprise one A and multiple B's, multiple A's and one B, or multiple A's and multiple B's.

## Claims

1. A method for locating a root of an outage in a power network, the method comprising using at least one hardware processor to:
obtain a prior probability distribution for a plurality of assets in a power network;
sample a first plurality of outage hypotheses from the prior probability distribution;
for each of the first plurality of outage hypotheses,
estimate one or more measurements in the power network based on a state of the plurality of assets in the outage hypothesis and a state of the plurality of assets that was estimated by a previously executed distribution state estimation,
compare the estimated one or more measurements to corresponding real-time measurements in the power network, and
weight the outage hypothesis based on the comparison;
resample a second plurality of outage hypotheses from the prior probability distribution based on the weightings of the first plurality of outage hypotheses;
compute a posterior probability distribution for the plurality of assets based on the second plurality of outage hypotheses; and
determine a location of each of one or more root assets, each representing a root of an outage in the power network, based on the posterior probability distribution.

2. The method of Claim 1, wherein each outage hypothesis identifies at least one of the plurality of assets, which is capable of carrying current, as being in an off state.

3. The method of any one of the preceding claims, wherein obtaining the prior probability distribution comprises computing the prior probability distribution using a probabilistic graphical model, and preferably wherein the probabilistic graphical model is a Bayesian network comprising a plurality of nodes that each represents a random variable, and a plurality of directed edges that each represents a dependency between a pair of the plurality of nodes.

4. The method of any one of the preceding claims, wherein the state of the plurality of assets that was estimated by a previously executed distribution state estimation comprises a nodal power injection at each of a plurality of nodes in the power network.

5. The method of any one of the preceding claims, wherein the distribution state estimation is executed periodically.

6. The method of any one of the preceding claims, wherein the method is triggered by one or more customer trouble calls, and further comprising using the at least one hardware processor to dispatch one or more field crews to the location of each of the one or more root assets.

7. The method of any one of the preceding claims, wherein estimating the one or more measurements in the power network comprises optimizing an objective function to minimize deviations between, for each of the plurality of assets that are in an off state in the outage hypothesis, a value of at least one parameter of that asset when in the off state and a value of that at least one parameter given values of decision variables that include the one or more measurements, preferably wherein the objective function comprises a quadratic function with one or more linear constraints, and preferably wherein the decision variables comprise one or more of voltage magnitudes, power injections, or line flows.

8. The method of any one of the preceding claims, wherein resampling the second plurality of outage hypotheses comprises, for each of the first plurality of outage hypotheses:
defining a proposal probability distribution from the prior probability distribution based on the outage hypothesis; and
in each of one or more iterations, until a condition is satisfied, resampling one or more outage hypotheses, to be added to the second plurality of outage hypotheses, from the proposal probability distribution using a resampling procedure,
preferably wherein the resampling procedure is a multinomial resampling procedure.

9. The method of Claim 8, wherein, in each of the one or more iterations, a parameter is increased, wherein the parameter represents randomness in the resampling procedure, and wherein the condition comprises the parameter satisfying a predefined threshold.

10. The method of either one of Claims 8 or 9, wherein the resampling procedure prioritizes higher weighted outage hypotheses in the first plurality of outage hypotheses over lower weighted outage hypotheses in the first plurality of outage hypotheses.

11. The method of any one of the preceding claims, wherein determining the location of each of the one or more outages comprises, for each of at least a subset of the plurality of assets:
determining a probability that the asset is in the off state based on the posterior probability distribution; and
when the probability satisfies one or more criteria, determining that the asset is in the off state.

12. The method of Claim 11, wherein determining the location of each of the one or more root assets further comprises determining, as the location of at least one of the one or more root assets, a most upstream asset that has been determined to be in the off state.

13. A system comprising:
at least one hardware processor; and
software that is configured to, when executed by the at least one hardware processor, perform the method of any one of Claims 1 through 12.

14. A non-transitory computer-readable medium having instructions stored thereon, wherein the instructions, when executed by a processor, cause the processor to perform the method of any one of Claims 1 through 12.

15. A computer program product comprising instructions that, when executed by a processor, cause the processor to perform the method of any one of Claims 1 through 12.
